Europäisches Patentamt

European Patent Office

Office européen des brevets

(19)

(11) Veröffentlichungsnummer : **0 054 608**
**B1**

# (12) EUROPÄISCHE PATENTSCHRIFT

(45) Veröffentlichungstag der Patentschrift :
13.03.85

(21) Anmeldenummer : 81105414.7

(22) Anmeldetag : 11.07.81

(51) Int. Cl.⁴ : **H 04 R 25/00, H 03 F 3/183,
H 03 G 5/10, H 03 G 5/12**

(54) **Aktive Tonblende für einen zwei- oder mehrstufigen Transistor-Hörgeräteverstärker.**

(30) Priorität : 18.12.80 DE 3047691

(43) Veröffentlichungstag der Anmeldung :
30.06.82 Patentblatt 82/26

(45) Bekanntmachung des Hinweises auf die Patenterteilung : 13.03.85 Patentblatt 85/11

(84) Benannte Vertragsstaaten :
AT CH DE LI NL

(56) Entgegenhaltungen :
FR-A- 2 289 090
INSTRUMENTS AND EXPERIMENTAL TECHNIQUES,
Band 15, Nr. 3, Mai-Juni 1972, Übersetzung von
November 1972, Seiten 763-764 New York, U.S.A.
YU.A. GOLUBEV et al.: "Preamplifier for signals from
semiconductor detectors based on field effect transistors"
NUCLEAR INSTRUMENTS AND METHODS, Band 174,
Nr. 3, August 1980, Seiten 357-362 Amsterdam, NL. Y.
ASANO et al.: "Test of iron liquid argon and leadliquid argon sampling calorimeters for detection of
electromagnetic showers"
FUNKSCHAU, Band 41, Nr. 19, 1. Oktober 1969,
Seiten 687-690 O. LIMANN: "Bedeutung, Schaltungstechnik und Aufbau von Hörgeräten"
SIEMENS Bauteile Report, Heft 4, September 1975, S.
104 bis 107

(73) Patentinhaber : ROBERT BOSCH GMBH
Postfach 50
D-7000 Stuttgart 1 (DE)

(72) Erfinder : Jerichow, Bernd, Ing.- grad.
Ribeckweg 14
D-1000 Berlin 37 (DE)

(74) Vertreter : Schmidt, Hans-Ekhardt
Robert Bosch GmbH Geschäftsbereich Elektronik
Patent- und Lizenzabteilung Forckenbeckstrasse
9-13
D-1000 Berlin 33 (DE)

## Beschreibung

### Stand der Technik

Die Erfindung geht aus von einer aktiven Tonblende nach der Gattung des Hauptanspruchs.

Es ist schon bekannt Robert Bosch GmbH, Geschäftsbereich Elektronik, Star 6ES, Reparaturhinweise, Impressum EK-VKD Nr. 8 699 944 496/12 605, Dezember 1976, bei einem mehrstufigen Transistor-Hörgeräteverstärker zwischen zwei aufeinanderfolgenden Transistorverstärkerstufen eine aktive Tonblende vorzusehen. Eine derartige Tonblende enthält einen Transistor, in dessen Zuleitung ein erster Kondensator liegt. Vor dem ersten Kondensator zweigt eine Leitung ab, die eine Reihenschaltung aus einem zweiten Kondensator, einem Widerstand mit einstellbarem Widerstandswert und einem dritten Kondensator besteht, der mit dem Kollektor des Transistors verbunden ist. Die Verbindungsstelle zwischen dem Widerstand einstellbaren Widerstandeswertes und dem dritten Kondensator bildet den Ausgang der Tonblende, der mit dem Eingang der folgenden Transistorverstärkerstufe verbunden ist.

Die beschriebene aktive Tonblendenschaltung hat den Nachteil, daß der Transistor kaum zur Verstärkung der mit dem Hörgeräteverstärker zu verstärkenden Niederfrequenzspannung beiträgt.

Es ist ferner bekannt (Funkschau, 1969, Heft 19, Seite 688), bei einer passiven Tonblende eine Parallelschaltung aus einem ersten Kondensator und der Serienschaltung eines zweiten Kondensators und eines einstellbaren Widerstandes vorzusehen.

### Vorteile der Erfindung

Die erfindungsgemäße Tonblende mit den kennzeichnenden Merkmalen des Hauptanspruchs hat den Vorteil, daß durch Hinzufügung eines einzigen weiteren Kondensators eine Tonblendenschaltung geschaffen wird, die sowohl eine Veränderung der Toncharakteristik der zu verstärkenden NF-Signale als auch eine ausreichende Verstärkung ergibt.

Durch die in den Unteransprüchen aufgeführten Maßnahmen sind vorteilhafte Weiterbildungen und Verbesserungen der im Hauptanspruch angegebenen Tonblende möglich. Besonders vorteilhaft ist eine Tonblende, bei der die Verstärkerstufe einen Transistor in Emitterschaltung enthält, dessen Kollektor über eine Reihenschaltung aus dem vierten Kondensator und einem zweiten, einen Lautstärkeeinsteller bildenden Widerstand einstellbaren Widerstandswertes mit dem Emitter des Transistors bzw. mit Masse verbunden ist, und bei der der mit dem Ausgang der Verstärkerstufe zu verbindende Anschluß des dritten Kondensators mit der Verbindungsstelle zwischen dem vierten Kondensator und dem zweiten Widerstand einstellbaren Widerstandeswertes verbunden ist. Bei der zuletzt beschriebenen Schaltungsart liefert die aktive Tonblende optimale Werte hinsichtlich der Einstellbarkeit der Toncharakteristik und der Verstärkung.

### Zeichnung

Ein Ausführungsbeispiel der Erfindung ist in der Zeichnung anhand zweier Figuren dargestellt und in der nachfolgenden Beschreibung näher erläutert. Die Zeichnung zeigt in

Figur 1 ein Schaltbild der erfindungsgemäßen aktiven Tonblende und

Figur 2 eine Kennlinie eines Hörgeräteverstärkers mit der erfindungsgemäßen aktiven Tonblende.

### Beschreibung der Erfindung

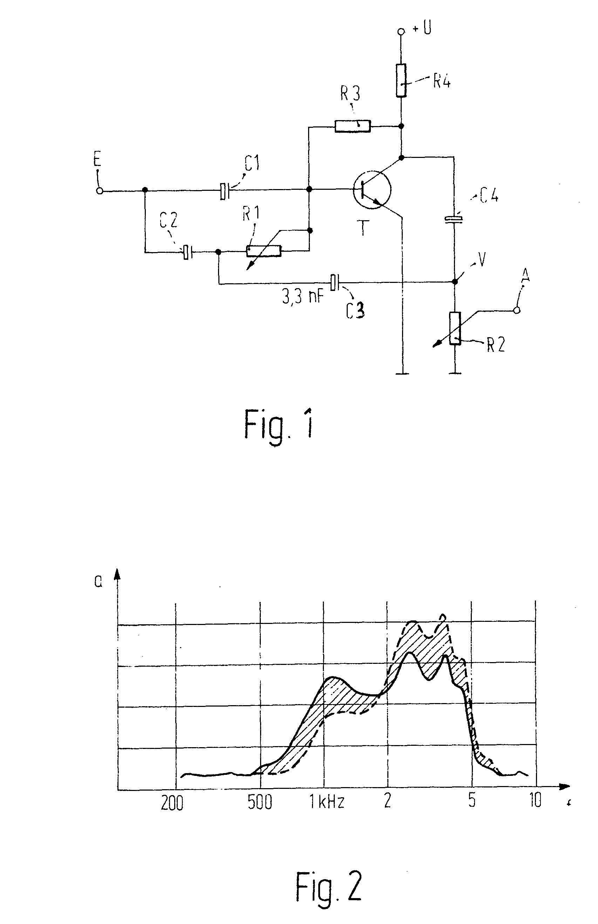

Die aktive Tonblende gemäß dem Schaltbild nach Fig. 1 weist einen Eingang E auf, der über einen ersten Kondensator C1 mit der Basis eines Transistors T verbunden ist. Dem ersten Kondensator C1 ist eine Reihenschaltung parallelgeschaltet, die aus einem zweiten Kondensator C2 und einem Widerstand R1 einstellbaren Widerstandswertes besteht. Die Verbindungsstelle zwischen dem zweiten Kondensator C2 und dem ersten Widerstand R1 einstellbaren Widerstandswertes ist über einen dritten Kondensator C3 mit einer Verbindungsstelle V verbunden, die einem vierten Kondensator C4 und einem als Lautstärkeregler dienenden zweiten Widerstand R2 einstellbaren Widerstandswertes gemeinsam ist. Der vierte Kondensator C4 und der zweite Widerstand R2 bilden eine Reihenschaltung, die zwischen dem Kollektor des Transistors T und dem Emitter- bzw. Massepotential liegt. Ein Abgriff des den Lautstärkeeinsteller bildenden zweiten Widerstandes R2 ist mit dem Ausgang A der Tonblende verbunden. Von dem Kollektor des Transistors T zweigt ein dritter Widerstand R3 ab, der eine Gleichstromverbindung zu der Basis des Transistors T herstellt, und ein vierter Widerstand R4, der mit einem Punkt positiven Potentials U verbunden ist.

Die Wirkungsweise der vorstehend beschriebenen Schaltung kann man sich so erklären, daß dem Transistor T eine passive Tonblende aus dem ersten Kondensator C1, dem zweiten Kondensator C2 und dem ersten Widerstand R1 einstellbaren Widerstandswertes vorgeschaltet ist und daß der dritte Kondensator C3 aus der passiven Tonblende eine aktive Tonblende macht. Auf diese Weise erhält man eine gute Einstellbarkeit der Toncharakteristik bei gleichzeitig guter Verstärkung. Damit kann auf eine zusätzliche Verstärkerstufe, die der sonst üblichen aktiven Tonblende nachgeschaltet werden muß, verzichtet werden.

Die mit dem ersten Widerstand R1 einstellbaren Widerstandswertes einstellbare Toncharakteristik des Hörgeräteverstärkers ist in einem Beispiel in Fig. 2 gezeigt. Der in Fig. 2 schraffierte Bereich stellt den Einstellbereich dar.

## Ansprüche

1. Aktive Tonblende für einen zwei- oder mehrstufigen Transistor-Hörgeräteverstärker, der zwischen Eingang (E) und Ausgang (A) einer Verstärkerstufe eine Widerstands-Kondensator-Kombination (C1, C2, R1) mit einem Widerstand (R1) einstellbaren Widerstandswertes (R1) enthält, dadurch gekennzeichnet, daß die in der Zuleitung zu einem Transistor (T) der Verstärkerstufe liegende Widerstands-Kondensator-Kombination (C1, C2, R1) aus einem ersten Kondensator (C1) und einer diesem Kondensator parallelgeschalteten Reihenschaltung aus einem zweiten Kondensator (C2) und einem ersten Widerstand (R1) einstellbaren Widerstandswertes besteht und daß zwischen dem zweiten Kondensator (C2) und dem Widerstand (R1) einstellbaren Widerstandswertes eine Leitung abzweigt, die über einen dritten Kondensator (C3) und einen vierten Kondensator (C4) mit dem Kollektor des Transistors der Verstärkerstufe in Verbindung steht, wobei das Ausgangssignal der Tonblende am Verbindungspunkt (V) dieser beiden Kondensatoren (C3, C4) abgreifbar ist.

2. Aktive Tonblende nach Anspruch 1, dadurch gekennzeichnet, daß die Verstärkerstufe einen Transistor (T) in Emitterschaltung enthält, dessen Kollektor über eine Reihenschaltung aus einem vierten Kondensator (C4) und einem weiteren, einen Lautstärkeeinsteller bildenden Widerstand (R2) einstellbaren Widerstandswertes mit dem Emitter des Transistors bzw. mit Masse verbunden ist, und daß der mit dem Ausgang der Verstärkerstufe zu verbindende dritte Kondensator (C3) mit der Verbindungsstelle zwischen dem vierten Kondensator und dem weiteren Widerstand einstellbaren Widerstandswertes verbunden ist.

## Claims

1. An active tone control circuit for a transistor hearing apparatus which has two or more stages and which includes between the input (E) and the output (A) of an amplifier stage a resistor/capacitor combination (C1, C2, R1) which includes a resistor (R1) having an adjustable resistance value, characterised in that the resistor/capacitor combination (C1, C2, R1) located in the lead to a transistor (T) of the amplifier stage comprises a first capacitor (C1) and a series combination which is connected in parallel with the said capacitor and which comprises a second capacitor (C2) and a first resistor (R1) having an adjustable resistance value, that a lead branches from the junction between the second capacitor (C2) and the resistor (R1) having an adjustable resistance value and is connected to the collector of the transistor of the amplifier stage by way of a third capacitor (C3) and a fourth capacitor (C4), the output signal of the tone control circuit being tappable from the junction (V) between the two said capacitors (C3, C4).

2. An active tone control circuit as claimed in claim 1, characterised in that the amplifier stage includes a transistor (T) which is connected in emitter configuration and whose collector is connected to the emitter of the transistor or to earth by way of a series combination comprising a fourth capacitor (C4) and a further resistor (R2) having an adjustable resistance value and forming a volume adjuster, and that the third capacitor (C3) to be connected to the output of the amplifier stage is connected to the junction between the fourth capacitor and the further resistor having an adjustable resistance value.

## Revendications

1. Réglage actif de tonalité pour un amplificateur à deux ou plusieurs étages d'un appareil de correction auditive à transistors, qui entre l'entrée (E) et la sortie (A) d'un étage d'amplification comporte une combinaison résistance-condensateurs ($C_1$, $C_2$, $R_1$) avec une résistance ($R_1$) de valeur réglable ($R_1$), réglage caractérisé en ce que la combinaison résistance-condensateurs placée sur le conducteur allant à un transistor (T) de l'étage d'amplification est constituée d'un premier condensateur ($C_1$) et d'un montage en série branché en parallèle, sur ce condensateur et constitué d'un second condensateur ($C_2$) et d'une première résistance ($R_1$) de valeur réglable, tandis qu'entre le second condensateur ($C_2$) et la résistance ($R_1$) de valeur réglable dérive un conducteur qui est relié, par l'intermédiaire d'un troisième condensateur ($C_3$) et d'un quatrième condensateur ($C_4$), au collecteur du transistor de l'étage d'amplification, le signal de sortie du réglage de tonalité étant susceptible d'être prélevé au point de jonction (V) de ces deux condensateurs ($C_3$, $C_4$).

2. Réglage actif de tonalité selon la revendication 1, caractérisé en ce que l'étage d'amplification comporte un transistor (T) dans le circuit d'émetteur, le collecteur de ce transistor étant relié à l'émetteur du transistor ou bien à la masse par l'intermédiaire d'un montage en série constitué d'un quatrième condensateur ($C_4$) et d'une autre résistance ($R_2$), de valeur réglable, constituant un organe de réglage du volume sonore, tandis que le troisième condensateur ($C_3$) devant être relié à la sortie de l'étage d'amplification, est relié au point de jonction entre le quatrième condensateur et cette autre résistance de valeur réglable.

Fig. 1

Fig. 2